Europäisches Patentamt

European Patent Office

Office européen des brevets

(11) Publication number: **0 090 669**
A2

# EUROPEAN PATENT APPLICATION

(21) Application number: 83301844.3

(22) Date of filing: 31.03.83

(51) Int. Cl.³: **H 01 L 31/08, H 01 L 31/02**

(30) Priority: 31.03.82 US 363980

(43) Date of publication of application: 05.10.83
**Bulletin 83/40**

(84) Designated Contracting States: **DE FR GB IT**

(71) Applicant: **HONEYWELL INC., Honeywell Plaza,
Minneapolis Minnesota 55408 (US)**

(72) Inventor: **Arch, David K., 5144-35th Avenue South,
Minneapolis Minnesota 55417 (US)**
Inventor: **Scott, Walter M., Dr., 15260 Highland Place,
Minnetonka Minnesota 55343 (US)**
Inventor: **Smith, Darryl Lyle, 5708 Creek Valley Road,
Edina Minnesota 55435 (US)**
Inventor: **Weisberg, Leonard R., 1225 LaSalle Avenue
No.1407, Minneapolis Minnesota 55403 (US)**
Inventor: **Wood, Roland A., 150 Mission Lane,
Bloomington Minnesota 55420 (US)**

(74) Representative: **Riddle, John et al, Honeywell Control
Systems Ltd. Patent Department Charles Square,
Bracknell, Berks. (GB)**

(54) **Electromagnetic radiation detector.**

(57) The electromagnetic radiation sensitive detector comprises a substrate (10), a first layer (12) on the substrate of radiation sensitive semiconductor material of a given conductivity type and having a first energy bandgap, at least one ohmic contact (16) providing electrical communication with the first layer, and a second layer (14) of semiconductor material of the same conductivity type as the first layer but having an energy bandgap greater than that of the first layer, the second layer being located on the first layer (12) beneath the or each contact (16) to which minority carriers are attracted from the first layer to enhance the responsivity of the detector.

- 1 -

## AN ELECTROMAGNETIC RADIATION DETECTOR

The present invention relates generally to semiconductor electromagnetic radiation detectors.

DESCRIPTION OF THE PRIOR ART

Photosensitive semiconductors are basically of two types, photoconductive and photovoltaic. When radiation of the proper energy falls upon a photoconductive semiconductor, the conductivity of the semiconductor increases. Energy supplied to the semiconductor causes covalent bonds to be broken, and electron-hole pairs in excess of those generated thermally are created. These increased current carriers decrease the resistance of the material. This "photoconductive effect" in semiconductor materials is used in photoconductive detectors.

If, on the other hand, the semiconductor sensor is such that it incorporates a pn junction, it gives rise to electron-hole pairs which create a potential difference in response to radiation of the proper energy. This is referred to as a "photovoltaic" effect. The semiconductor electromagnetic radiation detectors which we are concerned with are photoconductive detectors.

A photoconductive detector can be a bar of semiconductor material having electrical contacts at the ends. In its simplest use, the photoconductive detector is connected in series with a direct-current voltage source and a load resistor. The change in resistivity of the photoconductive detector in response to incident radiation is sensed.

To increase the photosensitivity or responsivity of the detector to the electromagnetic wavelengths, it has been discovered that this can be accomplished by reducing the rate of annihilation of the minority carriers to thereby increase or maximize the lifetime of the minority carriers generated by absorbed incident photons so that the excess majority carriers continue to flow for an increased length of time.

In general, most of the minority carriers are annihilated in one of three basic areas. These are within the detector bulk, at the surfaces of the detector including the surface exposed to the incident radiation, and at the electrical contacts to the detector.

The prior art teaches methods to reduce the rate of annihilation of the minority carriers within the detector bulk. One well known method for detectors of visible radiation is to incorporate impurities or lattice defects into the detector material which act to temporarily trap the minority carriers and thus reduce the rate of annihilation. Such a technique is described in R.B. Bube, "Photoconductivity of Solids" New York (1960), at p.69.

The prior art also teaches methods to prevent the minority carriers from recombining at the surface areas such as at the back of the detector or at the area exposed to the incident radiation by chemically or physically treating the surface or depositing a thin layer of a chemical compound on the surface. This is known as "passivation". Typically, the treatment creates electronic states on the surface which create an energy barrier that repels the minority carriers.

Unfortunately the prior art methods of passivating the surface create a layer at the surface that prevents or interferes with the formation of a good electrical contact. The existence of a good electrical contact means that majority carriers can be efficiently injected from the contact into the detector with no barrier or excessive resistance to their flow. Accordingly, either the surface has not been treated in the area in which the electrical contacts are placed, or the surface layer that is formed has been removed from the contact area prior to the formation of the electrical contacts. Thus, treatment has not been made directly under the electrical contacts.

An alternate approach to the protection of the surface exposed to the incident radiation in photovoltaic devices is to incorporate a layer of higher bandgap material at the sensitive area exposed to the incident radiation. Such a technique is described in the U.S. Patent 4,132,999. By that technique, however, the electrical contacts are caused to penetrate through the higher bandgap layer to the infrared sensitive material so that again there is no protection under the contacts. Yet another prior art approach involves the incorporation of a layer of higher doped material at the surface. That approach is described in U.S. Patent 4,137,544. As with the last described technique, however, the higher doped layer does not extend under the active portion of the electrical contacts.

A different prior art approach is described by M.A. Kinch et al (Infrared Physics, Volume 17, pp.137-145, 1977) in which the incident radiation is absorbed in a region that is not contiguous with the electrical contacts, i.e., geometrical separated from the electrical contacts. In this manner, the minority carriers that are generated by the incident radiation take a longer time to reach the contacts, thereby increasing the average life of the minority carriers.

In the case of infrared photoconductive detectors, operation is frequently in what is called the "sweepout" mode wherein the electrical contacts are placed quite close together on the semiconductor material. In this mode, to electrical field applied to the detector moves the minority carriers to the electrical contacts in a very short length of time. The time that the minority carriers take to reach the electrical contact is then so short that the possibility of the minority carriers being annihilated within the detector material is greatly reduced. Additionally, the effect of annihilation of minority carriers at the surfaces of the detector is also reduced. This rapid rate of annihilation of minority carriers by recombination at the electrical contact area can limit the responsivity of infrared detectors in general, and typically will limit the responsivity severely when the photoconductive detector is operated in the sweepout mode.

The full significance of this phenomenon has not generally been appreciated in the prior art.

A prior art attempt at a related solution is described by Y. J. Shacham-Diamand and I. Kidron (Infrared Physics, Vol. 21, p. 105, 1981) as a method to improve the responsivity by reducing the rate of recombination of minority carriers in the immediate vicinity of the electrical contacts to the semiconductor. This was accomplished by incorporating a built-in electric field opposing the collection of minority carriers under the cathode contacts. The built-in electric field resulted from the diffusion of donors into the $Hg_{1-x}Cd_xTe$ semiconductor which, in turn, resulted in a gradient in the electron concentration over about a two-micron region beneath the contact. Thus, the region under the contact was made $\underline{n}\pm$ if the detector material was n-type. Although some increase in responsivity of the detectors has been achieved by this approach, it has some inherent drawbacks. A disadvantage of this approach is that the added $\underline{n}+$ dopant leads to a decreasing minority carrier lifetime in the contact region which makes the system self-limiting in responsivity. In addition, the built-in electric field is limited by the solubility limit of the $\underline{n}^+$ dopant which reduces the blocking effect on the minority carriers.

Thus, the prior art has provided means for improving the responsivity of infrared detectors by reducing the rate of annihilation of minority carriers within the bulk of the infrared detector materials, and by preventing annihilation of minority carriers at surfaces of the detector that are not used for making electrical contacts to the detector. The prior art has further disclosed means of prolonging the lifetime of the minority carrier by using a geometry in which the electrical contacts are placed at an increased distance from the absorbed incident radiation.

According to the present invention, there is provided an improved semiconductor device comprising a substrate; a first layer on said substrate of electromagnetic radiation sensitive semiconductor material of a given conductivity type and having a first energy bandgap; and at least one ohmic contact for providing electrical communication with said first layer; characterized by a second layer of semiconductor material of the same conductivity type as said first layer but having a second energy bandgap greater than said first energy bandgap, said second layer being located on said first layer beneath the or each ohmic contact to which minority carriers are attracted from said first layer.

An embodiment of the invention will now be described by way of example, with reference to the accompanying drawings, in which:-

Figure 1 is a sectional view of an electromagnetic radiation detector of the present invention;

Figure 2A through 2J depict stages in one process for producing the detector of Figure 1; and

Figure 3 is a graph illustrating the improvement responsivity of a $Hg_{1-x}Cd_xTe$ detector of construction as illustrated in Figure 1.

DESCRIPTION OF THE PREFERRED EMBODIMENT

Infrared detectors include a class of materials with energy bandgaps in the range of infrared radiation, typically below 0.8 electron volts. This class includes, for example, materials such as $InAs_xSb_{1-x}$, $In_xGa_{1-x}Sb$, $PbS_{1-x}Sn_xTe$, and $Hg_{1-x}Cd_xTe$, where the quantity $\underline{x}$ is a number between 0 and 1 as appropriate to the properties desired. This class of detectors is referred to as "intrinsic" detectors. A second class of infrared detectors have larger energy bandgaps, but are doped with or have impurities added to provide sensitivity to infrared radiation. This class of material includes, for example, germanium or silicon doped with gold, and is called "extrinsic" detectors. The present infrared detector by way of example, will be described with specific reference to the well-known detector material $Hg_{1-x}Cd_xTe_x$.

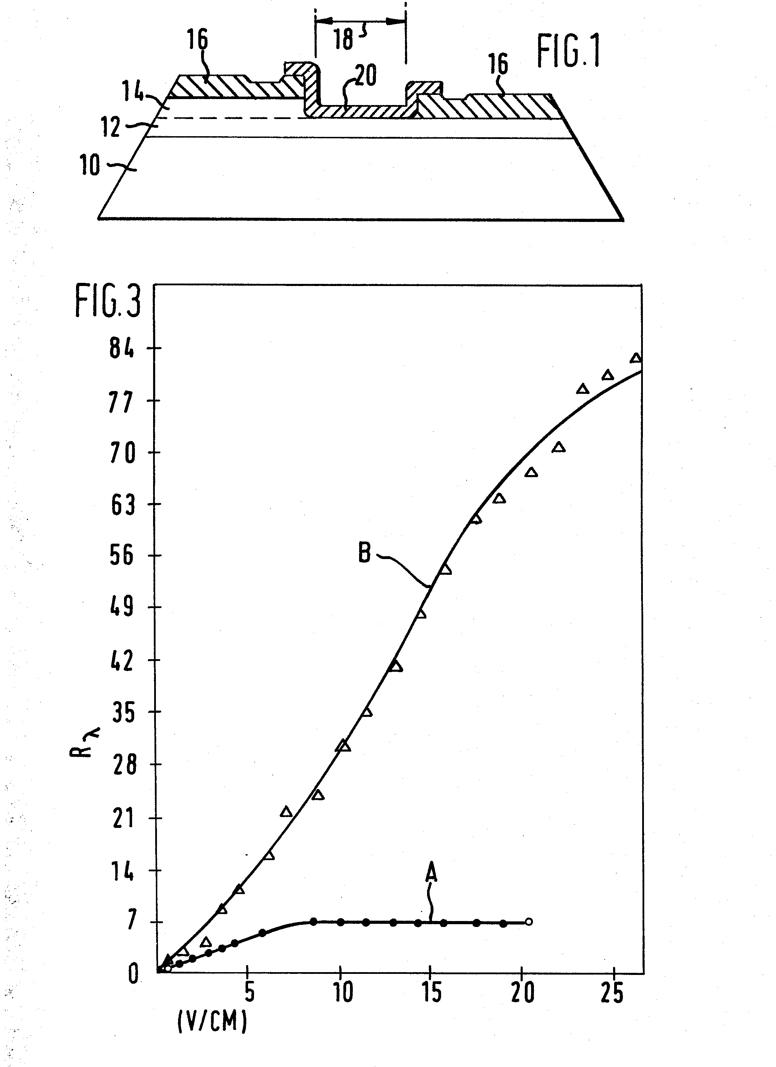

In the embodiment illustrated in Figure 1 a substrate 10 which may be CdTe supports a thin layer of the detector material 12, which may be $Hg_{1-x}Cd_xTe$. The value of $\underline{x}$ is greater than 0 but less than unity and in a typical detector is nominally between 0.1 and 0.4. The thickness of the layer 12 is generally from about $5x10^{-4}$ cm to about $15x10^{-4}$ cm. An area of the layer 12 is covered with a thin layer 14 which has a larger bandgap than the detector material. The larger bandgap thin layer 14 has a corresponding composition of $Hg_{1-y}Cd_yTe$ wherein $\underline{y}$ is greater than $\underline{x}$ of the layer 12 and has a thickness of from about $10^{-4}$ cm to about $10^{-3}$ cm. As discussed in greater detail below, both the layer 12 and the layer 14 may be formed by a growth process in which a thin layer is grown by liquid phase epitaxy onto the detector substrate material 10. Subsequently, a metal layer 16, compatible with and known to form an ohmic contact to either layer 12 or 14, is deposited as a thin layer onto the surface of layers 12 and 14 in the desired geometry to form the electrical contacts. The photoactive areas beneath the arrow at 18 may be provided with a thin surface passivation layer 20. Finally metal wires, not shown, are bonded to metal layers 16.

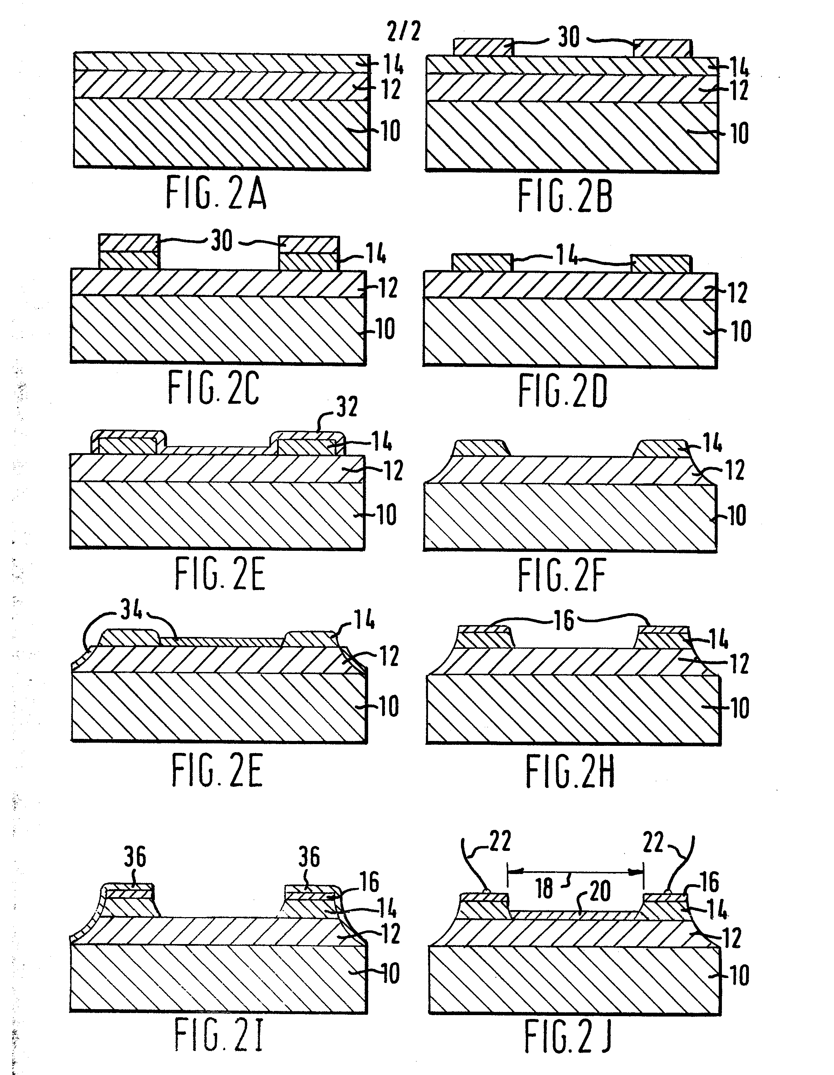

One successful embodiment of a photoconductor in accordance with Figure 1 was produced using the material HgCdTe according to a process which will now be described. The process is illustrated by Figures 2A-2j.

As illustrated in Figure 2A, a first thin layer 12 of $Hg_{1-x}Cd_xTe$ with $\underline{x}$ approximately equal to 0.20 was grown on a substrate of CdTe 10 utilizing liquid phase epitaxy techniques. Methods of growing such crystals by liquid phase epitaxy are well established in the art and one such technique is illustrated and described in U.S. Patent 3,902,924 .

This layer ultimately formed the photosensitive layer of the detector and was approximately $10^{-3}$ cm in thickness. Subsequently, a second thin layer 14 was grown on the first layer by similar techniques. The second layer reflected a small change in composition toward a higher bandgap alloy and was doped to the same concentration as the photosensitive layer. Thus, for a photosensitive layer 12 having a composition of $Hg_{0.80}Cd_{0.20}Te$ an overlayer 14 of composition $Hg_{0.78}Cd_{0.22}Te$ was used in one embodiment.

The photoconductor structure now included a top layer 14 of wider bandgap material approximately 5 microns in thickness. The surface was then solvent cleaned in a well-known manner and then pretreated with HMDS (hexamethyldisilizane) to promote surface adhesion followed by a photolithographic step (Figure 2B) using the photoresist material SC100 (Hunt Chemical). The first photolithographic step protected areas 30 on the wafer for delineation of the contacts. The photoresist was then exposed and developed

- 8 -

HMDS (hexamethyldisilizane) to promote surface adhesion followed by a photolithographic step (Figure 2B) using the photoresist material SC100 (Hunt Chemical). The first photolithographic step protected areas 30 on the wafer for delineation of the contacts. The photoresist was then exposed and developed leaving the resist in the geometry of the particular areas designated for the blocking contacts.

The higher bandgap material forming the top layer other than in the contact areas was then etched away (Figure 2C) utilizing a 1% bromine-methanol solution. The wafer was then dried in nitrogen gas and the photoresist stripped by plasma stripping.

As seen in Figure 2D, this left the blocking layer or higher bandgap energy layer 14 only in those areas directly delineated to be contact areas. The material 12 was exposed over the remainder of the surface.

A second photolithographic step, illustrated in Figure 2E, was utilized to delineate the desired photoconductive area of the device itself. After treatment with HMDS the wafer was coated at 32 with photoresist SC450 (Hunt Chemical) exposed and developed. The developed photoresist was then etched and dipped in a 1% Br-methanol rinse. The photoresist was stripped away by plasma stripping. This left the structure of Figure 2F

- 9 -

wherein the photosensitive layer 12 remained only in the area between the contacts.

The remainder of the fabrication was concerned with application of the actual contacts to the device and surface passivation of the photosensitive area of the device. In a third photoresist step, illustrated by Figure 2G, photoresist AZ1375 was applied and allowed to dry in a dry box. The photoresist was exposed, developed and rinsed. Subsequent to this an additional layer of photoresist AZ1470 was applied, baked, exposed and developed.

In the above manner, the entire photoconductive device was covered with a layer of photoresist shown at 34 except for the contact areas which were opened up for deposition of metal for ohmic contacts. Approximately 3300 $\overset{o}{A}$ of indium were evaporated onto the surface, followed by soaking in acetone to accomplish metal lift-off. This left a layer of indium at the points of desired ohmic contact, as illustrated by Figure 2H.

This was followed by a final photoresist step (Figure 2I) utilizing AZ1375 which was applied and developed to open up the photoactive area 18 for deposition of ZnS for surface passivation of the photoactive area. Approximately 1500 $\overset{o}{A}$ of ZnS at 20 (Figure 2J) utilizing a well-known RF sputtering technique in which approximately 750 $\overset{o}{A}$ were deposited at 150 w and the other

- 10 -

750 Å at 250 w. Metal leads were then attached in conventional fashion, and the finished detector of Figure 2J was produced.

It should be noted that the process example described herein calls for both ohmic contacts to be supplied with a higher bandgap layer 14 beneath the ohmic contact. As previously described and illustrated in Figure 1, passivation occurs only for the contact attracting the minority carriers, in this case the holes of the hole-electron pairs and therefore passivation is not necessary under both of the contacts. Because the input of majority carriers is not impeded by the layer 14, however, placing the layers under both contacts appears to be preferred, as it facilitates fabrication and use of the device. Of course, other variations are contemplated in the process in accordance with the practices of those skilled in the art.

Other well-known processes may be used to produce the electromagnetic radiation-sensitive semiconductor devices of the present invention. In addition to the liquid phase epitaxial growth process described, the semiconductor layers and regions may conveniently be grown by vapor phase epitaxy techniques. It is further contemplated that other processes including vacuum deposition and ion implantation may be utilized.

- 11 -

In addition to the $Hg_{1-x}Cd_xTe$ semiconductor materials described in regard to the preferred embodiment, other well-known materials including InSb, $InAs_xSb_{1-x}$, $In_xGa_{1-x}Sb$ and $Pb_{1-x}Sn_xTe$ may be employed. Such alternative processes and compound usages are well known to those skilled in the art.

The responsivity $R_\lambda$ $(\frac{KV}{WATT})$ of a detector having the composition profile illustrated in Figure 1 and which was processed in accordance with the above process is shown in Figure 3. Curve A was produced with the contact having the second or higher bandgap layer positively biased such that the minority carriers were not impeded as is the case with conventional detectors. Curve B was produced by reversing the leads so that minority carriers were impeded in accordance with the present invention. The conditions under which the measurements were made are given below:

| | |
|---|---|
| $T_{blackbody}$ | - 1000 Kelvin |
| Frequency | - 2K Hertz |
| Detector resistance | - 71 Ohms |
| Detector temperature | - 90 K |
| HRMS | - $1.5 \times 10^{-4}$ watts/cm$^2$ |
| Detector area | - $3.18 \times 10^{-5}$ cm$^2$ |
| Photoconductive layer | - x = 0.20 |
| Blocking layer | - y = 0.22 |

An enormous increase in $R_\lambda$ is observed when the contact that is negatively biased includes the second higher bandgap layer (i.e. when it is blocking) compared to when the contact that is negatively biased does not include the second higher bandgap layer (i.e. when it is ohmic). The saturation of $R_\lambda$ occurs at about 7 kV/W for the lower curve (A) at low bias fields. This indicates that sweepout has occurred at low

- 12 -

fields for a detector with conventional ohmic contacts.  On the other hand, as seen in curve B, $R_\lambda$ is greater than 70 kV/W and still increasing.

These results are most significant since they demonstrate the enhancement possible using the multilayer photoconductor detector structure described above.  Using a bias field of approximately 20 V/cm, the responsivity is seen to increase by a full factor of 10.

It is thus seen that an infrared detector may be processed so as to reduce the rate of recombination of the minority current carriers at the electrical contacts, without either impeding the flow of majority current carriers or significantly increasing the average carrier concentration of the semiconductor material since the barrier to minority carriers does not require increased majority carrier conentration.  In turn, this increases the lifetime of the minority carriers, which then increases the detector responsivity.

- 13 -

CLAIMS

1. A semiconductor device comprising a substrate; a first layer on said substrate of electromagnetic radiation sensitive semiconductor material of a given conductivity type and having a first energy bandgap; and at least one ohmic contact for providing electrical communication with said first layer; characterized by a second layer (14) of semiconductor material of the same conductivity type as said first layer but having a second energy bandgap greater than said first energy bandgap, said second layer being located on said first layer (12) beneath the or each ohmic contact (16) to which minority carriers are attracted from said first layer.

2. The semiconductor device according to Claim 1, characterized in that said first layer (12) of semiconductor material is $Hg_{1-x}Cd_xTe$, x being a number between 0.1, and 0.4; and in that said second layer of semiconductor material is $Hg_{1-y}Cd_yTe$, y being a number greater than x but less than unity.

3. The semiconductor device according to Claim 2, characterized in that y exceeds x by at least 0.01.

4. The semiconductor device according to any of Claims 1, 2 or 3, characterized in that said semiconductor material is of n-type.

5. The semiconductor device of Claim 1, characterized in that said semiconductor material is In.Sb, $InAs_xSb_{1-x}$, $In_xGa_{1-x}Sb$ or $Pb_{1-x}Sn_xTe$.

6. A semiconductor device according to Claim 2 or 3, characterized in that said layer of $Hg_{1-x}Cd_xTe$ has a thickness from $5x10^{-4}$ cm to $15-10^{-4}$ cm and said layer of $Hg_{1-y}Cd_yTe$ has a thickness from $10^{-4}$ cm to $10^{-3}$ cm.

7. The semiconductor device according to any of the preceding Claims, characterized in that the ohmic contact material is of indium.

8. The semiconductor device according to any one of the preceding Claims, characterized in that the semiconductor material is produced by epitaxial formation.

0090669

FIG.1

FIG.3

FIG.2A

FIG.2B

FIG.2C

FIG.2D

FIG.2E

FIG.2F

FIG.2E

FIG.2H

FIG.2I

FIG.2J